# EUROPÄISCHE PATENTSCHRIFT

(11) **EP 2 939 033 B1**
(45) Veröffentlichungstag und Bekanntmachung des Hinweises auf die Patenterteilung: **17.07.2019**
(21) Anmeldenummer: 13814510.7
(22) Anmeldetag: 18.12.2013
(51) Int. Cl.: G01R 1/073, G01R 31/28

(54) **KONTAKTKOPF ZUR BERÜHRUNGSKONTAKTIERUNG EINES ELEKTRISCHEN PRÜFLINGS**
CONTACT HEAD FOR TOUCH CONTACTING AN ELECTRIC TEST OBJECT
TÊTE DE CONTACT POUR CONTACT TACTILE D'UN OBJET DE TEST ÉLECTRIQUE

(30) Priorität: 29.12.2012 DE 202012012391 U
(43) Veröffentlichungstag der Anmeldung: 04.11.2015
(73) Patentinhaber: Feinmetall GmbH, 71083 Herrenberg (DE)
(72) Erfinder: SCHMID, Rainer, 72124 Pliezhausen (DE)
(74) Vertreter: Clarenbach, Carl-Philipp
(86) Internationale Anmeldenummer: PCT/EP2013/077034
(87) Internationale Veröffentlichungsnummer: WO 2014/102102

(56) Entgegenhaltungen:
- EP-A1- 1 243 931
- EP-A1- 1 524 529
- EP-A1- 2 060 922
- EP-A2- 0 344 654
- WO-A1-02/29423
- DE-A1-102006 028 141
- US-A1- 2001 011 897
- US-A1- 2009 096 474

## Beschreibung

Die Erfindung betrifft einen Kontaktkopf zur Berührungskontaktierung eines elektrischen Prüflings, insbesondere Wafers, mit in Aufnahmedurchbrüchen gelagerten Kontaktnadeln und mit mindestens zwei beabstandet zueinander angeordneten Führungsplatten sowie mit mindestens einer mit Abstand zu den Führungsplatten liegenden Offsetplatte, wobei die Führungsplatten Führungsdurchbrüche und die Offsetplatte Ausrichtdurchbrüche aufweisen, die Führungsdurchbrüche und die Ausrichtdurchbrüche die Aufnahmedurchbrüche bilden, und die Kontaktnadeln jeweils einen der Führungsdurchbrüche der einen Führungsplatte, einen der Führungsdurchbrüche der anderen Führungsplatte sowie einen der Ausrichtdurchbrüche der Offsetplatte durchsetzen.

Ein Kontaktkopf der eingangs genannten Art ist aus der DE 10 2006 028 141 A1 bekannt. Zur Durchführung einer elektrischen Prüfung eines elektrischen Prüflings wird der Prüfling mit seinen Prüfkontakten in Richtung auf den Prüfkopf derart verlagert, dass die prüflingsseitigen Enden von Kontaktnadeln des Prüfkopfs auf die Prüfkontakte aufsetzen. Die gegenüberliegenden Enden der Kontaktnadeln treten dabei gegen Kontaktflächen einer Leiterplatte. Die Leiterplatte dient einer Kontaktabstandsvergrößerung, d.h., die sehr eng beieinander liegenden Kontaktflächen sind über Leiterbahnen der Leiterplatte mit weiter beabstandet zueinander liegenden Kontakten verbunden, die mit einer Prüfvorrichtung elektrisch in Verbindung stehen. Mittels der Prüfeinrichtung werden Prüfstromkreise zum Prüfling geschaltet, um diesen auf Funktionsfähigkeit zu testen. Dieser Test wird sehr oft mit unterschiedlichen Temperaturen durchgeführt, um ferner eine Aussage über die Funktionsfähigkeit des Prüflings in einem entsprechend großen Temperaturbereich treffen zu können. Ist der Test durchgeführt, so werden Prüfkopf und Prüfling wieder voneinander getrennt. Hierbei kann es vorkommen, dass mindestens eine Kontaktnadel am zugehörigen Prüfkontakt haftet und dadurch gegebenenfalls ein Stück weit oder sogar vollständig aus dem Prüfkopf herausgezogen werden kann. Hierdurch werden Justagearbeiten zur Rückführung der mindestens einen Kontaktnadel oder es wird sogar die Einführung einer neuen Kontaktnadel erforderlich. Diese Arbeiten sind zeitintensiv und kostenaufwendig, wobei insbesondere zu berücksichtigen ist, dass der Kontaktabstand der Kontaktnadeln extrem gering ist, sodass derartige Arbeiten nur unter einem Mikroskop ausgeführt werden können.

Die Offenlegungsschriften US 2009/096474 A1, US 2001/011897 A1 und EP 1 524 529 A1 offenbaren jeweils einen Kontaktkopf mit zumindest einer Offsetplatte, die Ausrichtdurchbrüche zur Aufnahme von Kontaktnadeln aufweist. Die Ausrichtdurchbrüche gewährleisten eine Führung beziehungsweise Drehausrichtung von Kontaktnadeln des jeweiligen Kontaktkopfs, sodass beispielsweise durchgebogene Kontaktnadeln beim Kontaktieren eines Prüflings nicht miteinander in Berührkontakt treten.

Aus der Offenlegungsschrift US 2001/0011897 A1 ist es außerdem bekannt, eine Vielzahl von Offsetplatten zwischen zwei Führungsplatten anzuordnen und die Ausrichtdurchbrüche von zwei benachbarten Offsetplatten zueinander versetzt vorzusehen.

Der Erfindung liegt daher die Aufgabe zugrunde, einen Kontaktkopf der eingangs genannten Art zu schaffen, der eine sichere Kontaktierung des Prüflings gewährleistet und bei dem die Kontaktnadeln - trotz ihrer verschieblichen Lagerung im Kontaktkopf - im Zuge von Prüfarbeiten nicht dejustiert oder sogar herausgezogen werden.

Diese Aufgabe wird durch einen Kontaktkopf mit den Merkmalen des Anspruchs 1 gelöst. Erfindungsgemäß weisen die Ausrichtdurchbrüche jeweils eine Querschnittskontur auf, die in mindestens einer radialen Richtung einen Klemmrandkonturbereich und die in mindestens einer anderen radialen Richtung einen klemmfreien Randkonturbereich für den dort liegenden Querschnittsumriss der zugeordneten, zumindest einen Bogen aufweisenden Kontaktnadel besitzt. Bevorzugt ist vorgesehen, dass alle Ausrichtdurchbrüche jeweils die vorstehend erwähnte Querschnittskontur besitzen; es ist jedoch auch denkbar, dass nur einige Ausrichtdurchbrüche derart ausgebildet sind. Dadurch, dass die Kontaktnadeln jeweils mindestens einen Bogen aufweisen, bewegen sie sich im Bereich des Bogens durch das axiale Kontaktieren beziehungsweise Dekontaktieren des Prüflings in radialer Richtung. Diese Bewegung wird aufgrund des axialen Beaufschlagens ihrer jeweils zugehörigen beiden Enden und ihr elastisches Durchbiegen bewirkt. Beim Kontaktieren des Prüflings werden diese Enden entsprechend einer Kontaktierungskraft beaufschlagt; beim Dekontaktieren fehlt die Kontaktierungskraft. Die radiale "Ausweichbewegung" macht sich die Erfindung zunutze, indem in mindestens einer radialen Richtung des jeweiligen Ausrichtdurchbruchs die Querschnittskontur den Klemmrandkonturbereich aufweist und in mindestens einer anderen radialen Richtung der klemmfreie Randkonturbereich vorliegt. Der Klemmrandkonturbereich wirkt klemmend auf den sich dort radial hinbewegten Querschnittsumriss der zugeordneten Kontaktnadel. Der klemmfreie Randkonturbereich übt keine Klemmkraft auf den sich dort radial hinbewegten Querschnittsumriss der Kontaktnadel aus. Mithin führt die beim Kontaktieren beziehungsweise Dekontaktieren des Prüflings erfolgende radiale Verlagerungsbewegung eines entsprechenden Bereichs der Kontaktnadel dazu, dass der zugeordnete Querschnittsumriss entweder vom Klemmrandkonturbereich klemmend gehalten oder vom klemmfreien Randkonturbereich freigegeben wird. Die Anordnung ist derart getroffen, dass im dekontaktierten Zustand der Querschnittsumriss des Bereichs der Kontaktnadel mit dem Klemmrandkonturbereich zusammenwirkt und dass im kontaktierten Zustand eine Verlagerung des Bereichs der Kontaktnadel in den klemmfreien Randkonturbereich stattgefunden hat. Die Folge ist, dass im dekontaktierten Zustand ein Herausrutschen der Kontaktnadel aus ihren Aufnahmedurchbrüchen durch die vom Klemmrandkonturbereich hervorgerufene Klemmung verhindert ist. Da die Kontaktnadel zumindest einen Bogen besitzt, wird durch seitliches Anliegen an den Führungsdurchbrüchen beziehungsweise dem Ausrichtdurchbruch bereits ein Herausrutschen der Kontaktnadel im dekontaktierten Zustand des Kontaktkopfes erschwert. Aufgrund der Erfindung tritt die Klemmkraft des Klemmrandkonturbereichs hinzu, sodass ein sicheres Halten gewährleistet ist, selbst dann, wenn aufgrund einer zuvor durchgeführten Prüflingskontaktierung ein Haften des dem Prüfling zugeordneten Endes der Kontaktnadel am berührungskontaktierten Prüfkontakt des Prüflings stattgefunden hat. Die Haftkraft kann überwunden werden, ohne dass es zu einem teilweisen oder gänzlichen Herausziehen der Kontaktnadel aus den Aufnahmedurchbrüchen kommt.

Nach einer Weiterbildung der Erfindung ist vorgesehen, dass die Kontaktnadeln im nicht montierten Zustand einen geradlinigen Verlauf aufweisen. Sie erhalten durch das Einsetzen in die nicht fluchtenden Aufnahmedurchbrüche den erwähnten, mindestens einen Bogen. Alternativ ist des denkbar, dass die Kontaktnadeln Knicknadeln sind. Diese Knicknadeln besitzen im nicht montierten Zustand mindestens einen Bogen.

Insbesondere ist vorgesehen, dass die der jeweiligen Kontaktnadel zugeordneten Aufnahmedurchbrüche fluchtend und/oder versetzt zueinander angeordnet sind. Liegen die einer Kontaktnadel zugeordneten Aufnahmedurchbrüche fluchtend zueinander, so ist es erforderlich, eine Knicknadel zu verwenden, also eine Kontaktnadel, die im nicht montierten Zustand zumindest einen Bogen besitzt. Liegt zumindest einer der Aufnahmedurchbrüche für eine Kontaktnadel versetzt zu den beiden anderen Aufnahmedurchbrüchen, so kann entweder eine Kontaktnadel verwendet werden, die im nicht montierten Zustand einen geradlinigen Verlauf aufweist oder auch eine Knicknadel. Stets ist sichergestellt, dass die Kontaktnadel im eingesetzten Zustand mindestens einen Bogen besitzt. Entsprechendes gilt, wenn alle drei Aufnahmedurchbrüche seitlich versetzt zueinander liegen.

Nach einer Weiterbildung der Erfindung ist vorgesehen, dass die Führungsplatten und die Offsetplatte jeweils eben ausgebildet sind. Insbesondere ist vorgesehen, dass die Führungsplatten und die Offsetplatte parallel zueinander verlaufen.

Nach einem besonders bevorzugten Ausführungsbeispiel der Erfindung ist vorgesehen, dass die Offsetplatte zwischen den Führungsplatten angeordnet ist.

Nach einer bevorzugten Ausführungsform der Erfindung ist vorgesehen, dass die Ausrichtdurchbrüche jeweils nur einen einzigen Klemmrandkonturbereich aufweisen. Denkbar ist im Gegensatz dazu jedoch auch die Ausführung, dass ein und derselbe Ausrichtdurchbruch mehrere Klemmrandkonturbereiche besitzt, beispielsweise dann, wenn nicht sichergestellt werden kann, dass die zugeordnete Kontaktnadel stets in derselben radialen Richtung eine Bewegung durchführt. Vorzugsweise kann Entsprechendes für den klemmfreien Randkonturbereich des Ausrichtdurchbruchs gelten, d.h., es ist nur ein klemmfreier Randkonturbereich vorhanden oder es sind mehrere klemmfreie Randkonturbereiche an ein und demselben Ausrichtdurchbruch ausgebildet.

Bevorzugt ist jedoch, dass nur ein einziger Klemmrandkonturbereich und nur ein einziger klemmfreier Randkonturbereich bei ein und demselben Ausrichtdurchbruch vorgesehen ist, wobei vorzugsweise Klemmrandkonturbereich und klemmfreier Randkonturbereich einander diametral gegenüberliegen, also in um 180° zueinander versetzt liegenden, radialen Richtungen liegen.

Erfindungsgemäß ist vorgesehen, dass der Klemmrandkonturbereich einen sich in radialer Richtung verengenden Klemmspalt für die zugeordnete Kontaktnadel bildet. Der Klemmspalt verengt sich somit in Abhängigkeit der radialen Richtung derart, dass weiter außen liegend der Klemmspalt enger ist als weiter innen liegend. Hierbei beziehen sich die Begriffe "außen" und "innen" auf den Abstand zu einen gedachten Mittelpunkt der Querschnittskontur des Ausrichtdurchbruchs.

Bevorzugt ist vorgesehen, dass die Querschnittskonturen der Ausrichtdurchbrüche tropfenförmige Konturen oder ähnlich tropfenförmiger Konturen ausgebildet sind. Dies bedeutet, dass sie einen durchmessergrößeren Bereich besitzen und davon ausgehend einen im Durchmesser kleineren Bereich, wobei der Durchmesser umso kleiner wird, je weiter die Entfernung vom betrachteten Mittelpunkt ist.

Nach einem bevorzugten Ausführungsbeispiel der Erfindung ist vorgesehen, dass die Bogenrichtung des Bogens der jeweiligen Kontaktnadel entgegengesetzt zur radialen Richtung des zugeordneten Klemmrandkonturbereichs verläuft. Die "Bogenrichtung" des Bogens ist dabei derart definiert, dass sie - ausgehend von einer gedachten, geradlinigen Längsmittellinie der Kontaktnadel - in Richtung auf den Scheitel des Bogens weist. Durch die entgegengesetzten radialen Richtungen von Bogenrichtung und radialer Richtung des zugeordneten Klemmrandkonturbereichs ist sichergestellt, dass sich die beim Dekontaktieren "entspannende" Kontaktnadel mit ihrem entsprechenden Querschnittsumriss derart bewegt (insbesondere Radiusvergrößerung des Bogens), dass der Querschnittsumriss in den Klemmrandkonturbereich gelangt und dort klemmend gehalten wird.

Bevorzugt ist vorgesehen, dass - insbesondere im kontaktierten Zustand des Prüfkopfs - die der Bogenrichtung des Bogens entgegengesetzte radiale Richtung mit der radialen Richtung des zugeordneten Klemmrandkonturbereichs einen spitzen Winkel α einschließt. Hierdurch wird sich beim Übergang des zugeordneten Querschnittsumrisses von dem Klemmrandkonturbereich in den klemmfreien Randkonturbereich beziehungsweise vom klemmfreien Randkonturbereich in den Klemmrandkonturbereich ein Drehmoment einstellen, mit der Folge, dass sich die Berührungskontaktierung der Kontaktnadel verbessert, denn eine aus dem Drehmoment resultierende Drehbewegung der Kontaktnadel führt zu einer Relativbewegung zur entsprechenden Kontaktfläche, wodurch beispielsweise eine Verschmutzung und/oder Oxidschicht durchdrungen und ein niederohmiger Berührungskontakt erzeugt wird.

Bevorzugt ist vorgesehen, dass die Kontaktnadeln jeweils zumindest in ihrem den Ausrichtdurchbruch durchsetzten Bereich eine Isolierung aufweisen. Insbesondere ist vorgesehen, dass die Führungsdurchbrüche der dem Prüfling zugewandt liegenden Führungsplatte jeweils einen Querschnitt aufweisen, der kleiner ist als der mit Isolierung versehene Querschnitt der zugeordneten Kontaktnadel, wobei die Isolierung an der dem Prüfling abgewandt liegenden Oberfläche dieser Führungsplatte endet. Die Isolierung verläuft also bis auf die dem Prüfling abgewandt liegende Oberfläche der dem Prüfling zugewandt liegenden Führungsplatte. Dies bedeutet, dass der Führungsdurchbruch dieser Führungsplatte nur so groß ist, dass ein abisolierter Bereich der Kontaktnadel dort hindurchpasst, der mit Isolierung versehene Durchmesser jedoch so groß ist, dass die Isolierung auf die genannte Oberfläche aufsetzt, sich dort also axial abstützt und insofern einen Herausziehschutz für die Kontaktnadel bildet. Dieser Herausziehschutz wird durch die erfindungsgemäße Klemmung mittels des Klemmrandkonturbereichs noch weiter verbessert.

Insbesondere kann vorgesehen sein, dass die Isolierungen der Kontaktnadeln durch die Klemmwirkungen der Klemmrandkonturbereiche bewirkte Einkerbungen oder Durchtrennungen aufweisen. Durch die Klemmwirkung des jeweiligen Klemmrandkonturbereichs wird die Isolierung klemmend beaufschlagt, mit der Folge, dass hierdurch eine Einkerbung/Stufe oder dergleichen in die Isolierung eingeprägt wird. Im Extremfall kann es auch zur Durchtrennung der Isolierung kommen. Die Einkerbung beziehungsweise Stufe bleibt jedoch auch bei einer Durchtrennung bestehen. Durch das axiale Abstützen der Einkerbung beziehungsweise Stufe an dem Klemmrandkonturbereich wird die Rückhaltewirkung nochmals verstärkt, d.h., die jeweilige Kontaktnadel wird noch sicherer gegen teilweises oder sogar vollständiges Herausziehen gehalten.

Schließlich ist insbesondere vorgesehen, dass die Isolierung aus Kunststoff, insbesondere Polyimid, besteht. Dieser Werkstoff stellt einerseits eine gute elektrische Isolierung sicher und lässt andererseits die Ausbildung einer Einkerbung/Stufe, Durchtrennung oder dergleichen durch die Klemmwirkung des Klemmrandkonturbereichs zu.

Die Zeichnungen veranschaulichen die Erfindung anhand von Ausführungsbeispielen und zwar zeigt:
- Figur 1: eine schematische Seitenansicht auf einen mit Kontaktnadeln versehenen Kontaktkopf zur Berührungskontaktierung eines elektrischen Prüflings,
- Figur 2: eine schematische Seitenansicht auf eine der Kontaktnadeln des Kontaktkopfs,
- Figur 3: eine schematische Seitenansicht eines Bereichs des Kontaktkopfs im dekontaktierten Zustand,
- Figur 4: eine Darstellung entsprechend der Figur 3, jedoch im kontaktierten Zustand,
- Figur 5: zwei Querschnittsansichten auf einen Ausrichtdurchbruch des Kontaktkopfs mit sich im dekontaktierten und im kontaktierten Zustand befindlicher Kontaktnadel,
- Figur 6: ein erstes Ausführungsbeispiel des Ausrichtdurchbruchs mit einer Darstellung der Bogenrichtung der Kontaktnadel,
- Figur 7: ein zweites Ausführungsbeispiel des Ausrichtdurchbruchs mit einer Darstellung der Bogenrichtung der Kontaktnadel,
- Figur 8: ein drittes Ausführungsbeispiel des Ausrichtdurchbruchs mit einer Darstellung der Bogenrichtung der Kontaktnadel und
- Figur 9: einen Bereich des Kontaktkopfs mit Kontaktnadel, die mit einer Isolierung versehen ist und sich im dekontaktierten Zustand befindet.

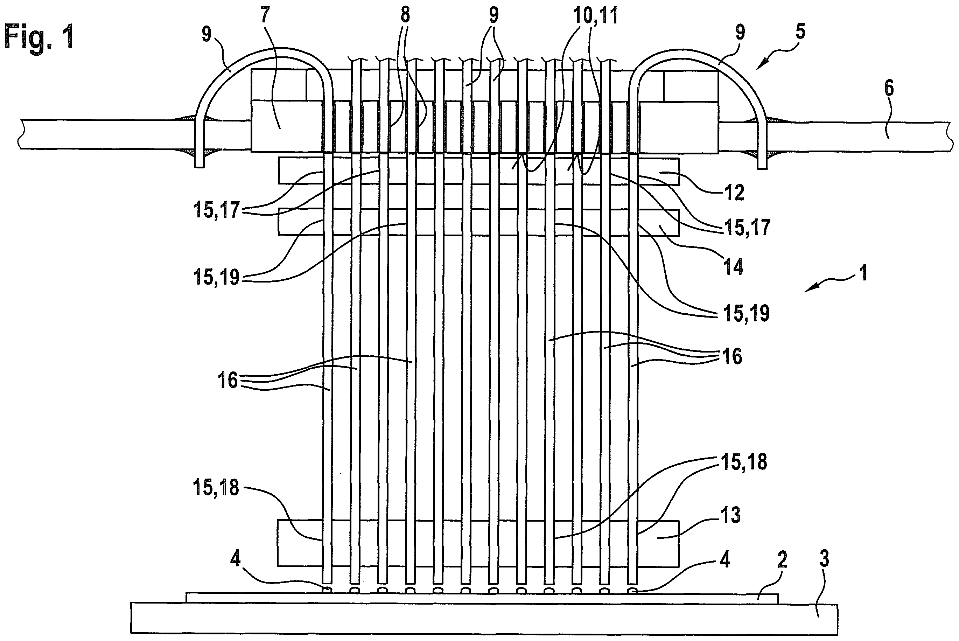

Die Figur 1 zeigt einen Kontaktkopf 1. Der Kontaktkopf 1 dient zur Berührungskontaktierung eines elektrischen Prüflings 2, der insbesondere als Wafer ausgebildet sein kann. Der Prüfling 2 ist auf einem Hebetisch 3 angeordnet. Er weist eine Vielzahl von Prüfkontakten 4 auf. Oberhalb des Kontaktkopfs 1 befindet sich eine Kontaktabstandumsetzeinrichtung 5, die eine Leiterplatte 6 aufweist. Die Leiterplatte 6 ist mit einem Einsatz 7 versehen, der Bohrungen 8 aufweist. Die Bohrungen 8 werden von Anschlussdrähten 9 durchsetzt, die bogenförmig zur Leiterplatte 6 geführt und dort an ihrem Endbereich mit Leiterbahnen der Leiterplatte 6 elektrisch verbunden sind. Die anderen Endbereiche der Anschlussdrähte 9 weisen plangeschliffene Stirnflächen 10 auf, die Kontaktflächen 11 bilden. Die zugehörigen Endbereiche der Anschlussdrähte 9 sind in den Bohrungen 8 vergossen und daher dort festgelegt. Aus dem Vorstehenden wird deutlich, dass der sehr enge Abstand der Kontaktflächen 11 aufgrund der bogenförmig geführten Anschlussdrähte 9 aufgeweitet wird, wobei eine weitere Aufweitung dadurch erfolgt, dass die Leiterbahnen der Leiterplatte 6 zur Peripherie der Leiterplatte 6 führen, wo sie über elektrische Leitungen mit einer Prüfeinrichtung verbunden sind (nicht dargestellt).

Der Prüfkopf 1 weist gemäß Figur 1 zwei Führungsplatten 12 und 13 sowie eine Offsetplatte 14 auf. Letztere wird üblicherweise auch als sogenannte Vorsetzplatte bezeichnet. Die Führungsplatten 12 und 13 sind eben ausgebildet. Die Offsetplatte 14 ist ebenfalls eben gestaltet. Die Offsetplatte 14 ist vorzugsweise zwischen den beiden Führungsplatten 12 und 13 angeordnet. Die Führungsplatten 12 und 13 und die Offsetplatte 14 verlaufen parallel zueinander. Sie sind vorzugsweise mittels nicht dargestellter Abstandshalter in fester Relation zueinander gehalten, wobei sich insbesondere die der Leiterplatte 6 näher liegende Führungsplatte 12 und die Offsetplatte 14 in engerem Abstand zueinander befinden als die Offsetplatte 14 zu der prüflingsnahen Führungsplatte 13.

Die beiden Führungsplatten 12 und 13 und die Offsetplatte 14 sind mit Aufnahmedurchbrüchen 15 versehen, in denen Kontaktnadeln 16 gelagert sind. Dieses "Lagern" erfolgt durch einfaches Einschieben der Kontaktnadeln 16 in die Aufnahmedurchbrüche 15. Die Anordnung ist vorzugsweise derart getroffen, dass jeweils eine Kontaktnadel 16 einen Aufnahmedurchbruch 15 der Führungsplatte 12, einen Aufnahmedurchbruch 15 der Führungsplatte 13 und einen Aufnahmedurchbruch 15 der Offsetplatte 14 durchsetzt. Die Aufnahmedurchbrüche 15 der Führungsplatten 12 und 13 sind als Führungsdurchbrüche 17, 18 und die Aufnahmedurchbrüche 15 der Offsetplatte 14 als Ausrichtdurchbrüche 19 ausgebildet. Die Anordnung ist vorzugsweise derart getroffen, dass die Kontaktnadeln 16 einen kreisförmigen Querschnitt aufweisen und dass die Führungsdurchbrüche 17 und 18 ebenfalls mit kreisförmigem Querschnitt versehen sind. Die Querschnittsform der Ausrichtdurchbrüche 19 weicht von den Querschnittsformen der Führungsdurchbrüche 17 und der Kontaktnadeln 16 ab. Auf ihre Ausgestaltung wird nachstehend näher eingegangen.

Aus der Figur 1 ist zu erkennen, dass der Abstand der Kontaktflächen 11 und ihre Anordnung zueinander dem Abstand und der Anordnung der Kontaktnadeln 16 sowie der Prüfkontakte 4 des Prüflings 2 entspricht. Hieraus resultiert, dass ein mittels des Hubtisches 3 angehobener Prüfling 2 gegen die prüflingsseitigen Enden 23 der Kontaktnadeln 16 gedrängt werden, wodurch die leiterplattenseitigen Enden 25 der Kontaktnadeln 16 gegen die Kontaktflächen 11 der Anschlussdrähte 9 treten, sodass der Kontaktkopf 1 eine elektrische Berührungskontaktierung zum Prüfling 2 herstellt. Mittels der vorstehend erwähnten Prüfeinrichtung, die mit der Leiterplatte 6 elektrisch verbunden ist, lassen sich Prüfstromkreise schalten. Mit den Prüfstromkreisen wird der elektrische Prüfling 2 auf Funktionsfähigkeit geprüft. Diese Prüfung kann bei unterschiedlichen Temperaturen erfolgen, um die Funktionsfähigkeit des Prüflings 2 auch in einem Temperaturbereich zu testen. In diesem Zusammenhang soll erwähnt werden, dass es sich im Falle eines Wafers als Prüfling 2 um eine extrem kleine Anordnung handelt, d.h., die Kontaktnadeln 16 sind so dünn wie ein Frauenhaar und liegen extrem eng beieinander. Auch ist die Anzahl der im Kontaktkopf 1 geführten Kontaktnadeln 16 oft sehr groß. Die Figur 1 ist daher nur als schematische Ansicht zu werten, wobei nur eine Ebene dargestellt ist. In der Realität handelt es sich bei dem Prüfkopf 1 um eine dreidimensionale Anordnung. Um derart kleine Abmessungen zu realisieren, werden als Führungsplatten 12, 13 und Offsetplatte 14 meist Keramikplatten verwendet, bei denen die Aufnahmedurchbrüche 15 per Laserstrahl gebohrt werden.

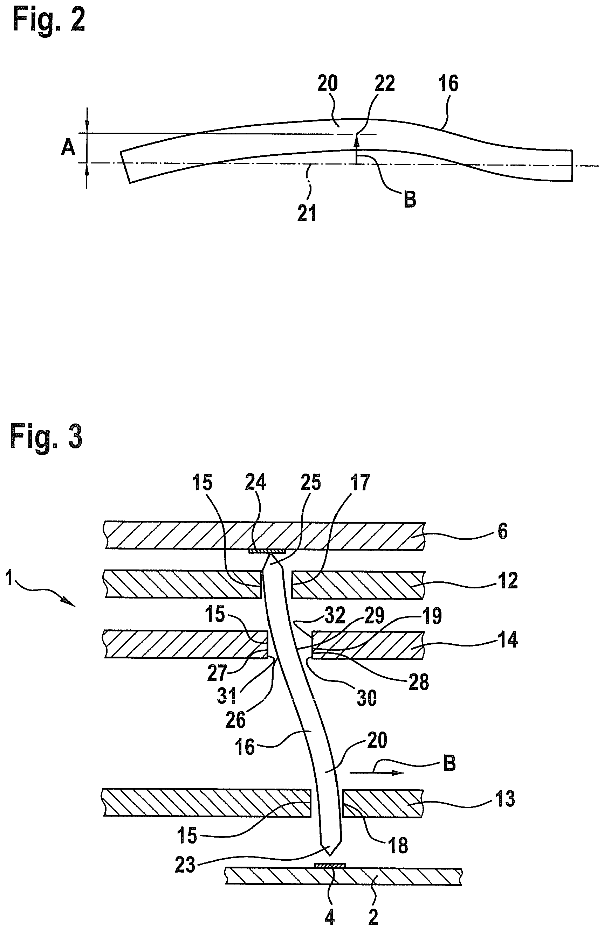

In der Figur 1 hat es den Anschein, als würden die Kontaktnadeln 16 geradlinig verlaufen und die jeder Kontaktnadel 16 zugeordneten Aufnahmedurchbrüche 15 miteinander fluchten. Tatsächlich verlaufen die Kontaktnadeln 16 jedoch bogenförmig, so wie dies der Figur 2 zu entnehmen ist. Dort ist eine der Kontaktnadeln 16 mit mindestens einem Bogen 20 dargestellt. Nachstehend soll hierauf näher eingegangen werden, wobei die Ausführungen auf einen Bogen 20 beschränkt bleiben. Bei der Erfindung kann eine Kontaktnadel 16 jedoch auch mehr als nur einen Bogen 20 aufweisen. Entlang ihrer Längserstreckung weist die Kontaktnadel 16 also gemäß Figur 2 den Bogen 20 auf. Geht man von einer Längsmittellinie 21 der Kontaktnadel 16 aus, wobei die Längsmittellinie 21 geradlinig verläuft, so besitzt der Bogen 20 zu dieser Längsmittellinie 21 in Bezug auf seinen Bogenscheitel 22 einen Abstand, der das Maß A aufweist. Ferner wird eine Bogenrichtung B des Bogens 20 definiert, nämlich ausgehend von der Längsmittellinie 21 zum Bogenscheitel 22 des Bogens 20. Die Bogenrichtung B steht senkrecht auf der Längsmittellinie 21.

Um den mindestens einen Bogen 20 der Kontaktnadel 16 herbeizuführen ist entweder vorgesehen, dass die Kontaktnadel 16 als sogenannte Knicknadel ausgebildet ist. Dies bedeutet, dass sie im nicht montierten Zustand, wenn sie sich also nicht in den Aufnahmedurchbrüchen 15 befindet, mindestens einen Bogen 20 aufweist. Alternativ ist es möglich, dass die Kontaktnadel 16 im nicht montierten Zustand geradlinig ausgebildet ist und dass der mindestens eine Bogen dadurch gebildet wird, dass die Aufnahmedurchbrüche 15 des Kontaktkopfs 1 nicht miteinander fluchten. Die Kontaktnadel 16 besteht aus einem elektrisch gut leitenden Werkstoff, der eine hinreichende Elastizität zur Bogenbildung besitzt. Als weitere Möglichkeit ist es denkbar, dass die Kontaktnadel 16 als Knicknadel ausgebildet ist und gleichwohl die ihr zugeordneten Aufnahmedurchbrüche 15 nicht fluchtend zueinander angeordnet sind. Stets ergibt sich eine Anordnung, so wie sie in der Figur 3 schematisch dargestellt ist.

Die Figur 3 zeigt die Lagerung einer der Kontaktnadeln 16 in den Aufnahmedurchbrüchen 15 der Führungsplatten 12 und 13 sowie der Offsetplatte 14. Die Offsetplatte 14 ist - wie bereits aus der Figur 1 ersichtlich - zwischen den beiden Führungsplatten 12 und 13 angeordnet. Es ist aus der Figur 3 ersichtlich, dass ausgehend vom Führungsdurchbruch 17 der Führungsplatte 12 der Ausrichtdurchbruch 19 der Offsetplatte 14 seitlich versetzt liegt, dass also der Führungsdurchbruch 17 nicht mit dem Ausrichtdurchbruch 19 fluchtet. Der Führungsdurchbruch 18 der Führungsplatte 13 liegt wiederum seitlich versetzt zum Ausrichtdurchbruch 19 der Offsetplatte 14, sodass also der Ausrichtdurchbruch 19 ebenfalls nicht mit dem Führungsdurchbruch 18 fluchtet und dass vorzugsweise auch ferner die beiden Führungsdurchbrüche 17 und 18 nicht miteinander fluchten. Die Folge ist, dass die die Führungsdurchbrüche 17 und 18 sowie den Ausrichtdurchbruch 19 durchsetzende Kontaktnadel 16 den aus der Figur 3 ersichtlichen bogenförmigen Verlauf aufweist. Dieser bogenförmige Verlauf ist zum Beispiel S-förmig gestaltet, d.h., die Kontaktnadel 16 besitzt zumindest einen Bogen 20 mit einer in der Figur 3 nach rechts weisenden Bogenrichtung B. Dieser vorstehend beschriebene Zustand liegt vor, wenn keine Kontaktierung des Prüflings 2 erfolgt. Aus der Figur 3 ist ersichtlich, dass das prüflingsseitige Ende 23 der Kontaktnadel 16 mit Abstand zum zugeordneten Prüfkontakt 4 des Prüflings 2 liegt. In der Figur 3 ist gegenüber der Figur 1 eine andersartige Ausgestaltung der Leiterplatte 6 dargestellt. Diese besitzt Kontaktflächen 24, die den Kontaktflächen 11 des Ausführungsbeispiels der Figur 1 entsprechen, jedoch nicht von Stirnflächen von Anschlussdrähten 9 gebildet sind. Die Funktion der Kontaktabstandumsetzeinrichtung 5, der die Leiterplatte 6 angehört, ist jedoch bei den Figuren 1 und 3 entsprechend gleich.

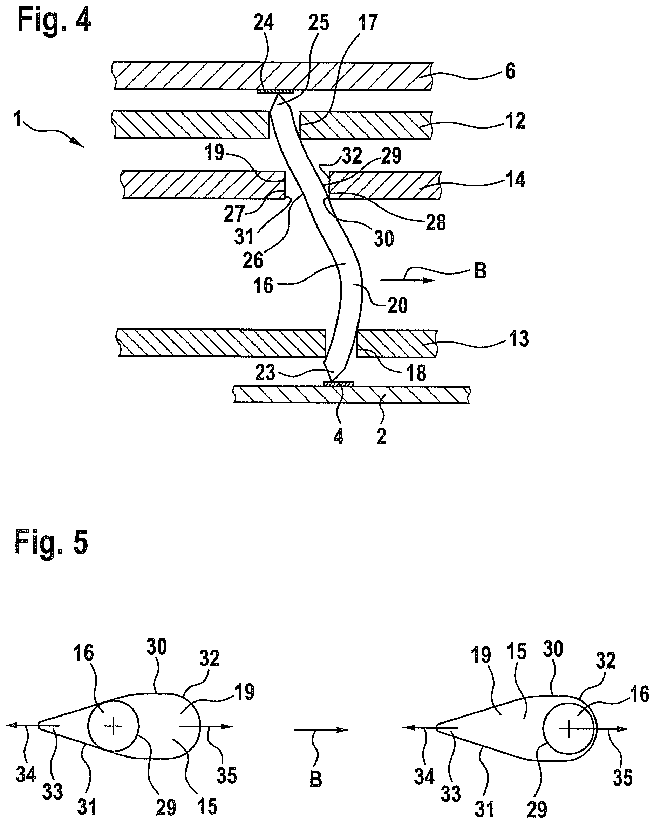

Ein Vergleich der Figur 3 mit der Figur 4 macht deutlich, wie sich die Situation verändert, wenn ein kontaktierter Zustand vorliegt, wenn also der Prüfling 2 derart weit in Richtung auf den Kontaktkopf 1 verlagert ist, dass sich das Ende 23 der Kontaktnadel 16 am Prüfkontakt 4 des Prüflings 2 abstützt, sodass dort eine elektrische Berührungskontaktierung erfolgt und dass sich das gegenüberliegende Ende 25 der Kontaktnadeln 16 an der Kontaktfläche 24 abstützt, sodass auch dort eine elektrische Berührungskontaktierung vorliegt. Die Kontaktnadel 16 wird also etwa in ihrer axialen Richtung kraftbeaufschlagt, wodurch sie sich gegenüber der Gestalt der Figur 3 stärker durchbiegt. Dies ist der Figur 4 deutlich entnehmbar. Der Bogen 20 hat seine Bogenrichtung B beibehalten, jedoch ist das Maß A des Bogens 20 in der Figur 4 wesentlich größer als in der Figur 3 (vergleiche hierzu auch Figur 2). Die Folge dieser vergrößerten Durchbiegung ist, dass ein den Ausrichtdurchbruch 19 der Offsetplatte 14 durchsetzender Bereich 26 der Kontaktnadel 16 zunächst an dem linksseitigen Randabschnitt 27 anliegt (Figur 3), dann jedoch radial durch die stärkere Biegung der Kontaktnadel 16 verlagert wird, sodass der Bereich 26 gemäß Figur 4 am rechtsseitigen Randabschnitt 28 des Ausrichtdurchbruchs 19 zu liegen kommt. Gegenüber dem nicht kontaktierten Zustand gemäß Figur 3 verlagert sich demzufolge zumindest ein Bereich 26 der Kontaktnadel 16 radial, wenn der kontaktierte Zustand eingenommen wird.

Von Bedeutung für die Erfindung ist, dass der Ausrichtdurchbruch 19 einen asymmetrischen Querschnitt aufweist. Dieser asymmetrische Querschnitt verjüngt sich in einer radialen Richtung, mit der Folge, dass auf die Kontaktnadel 16 eine Klemmung ausgeübt wird, wenn sie im sich verjüngenden Bereich einliegt. Wie vorstehend erläutert, führt das Kontaktieren und Dekontaktieren des Prüflings 2 zu einer Radialverlagerung zumindest des Bereichs 26 der Kontaktnadel 16, mit der Folge, dass sich der Bereich 26 entweder in dem sich verjüngenden Bereich des asymmetrischen Ausrichtdurchbruchs 19 oder in dem sich nicht verjüngten Bereich befindet, dass also entweder eine Klemmung der Kontaktnadel 16 oder keine Klemmung erfolgt. Vorzugsweise ist die Anordnung derart getroffen, dass die Klemmung stattfindet, wenn der nicht kontaktierte Zustand der Kontaktnadel 16 vorliegt und dass die Klemmung aufgehoben wird, sobald die Kontaktierung vorgenommen wird. Die erwähnte Klemmung kommt - mit anderen Worten - dadurch zustande, dass der Querschnittsumriss 29 der Kontaktnadel 16, insbesondere der Querschnittsumriss 29 im Bereich 26 der Kontaktnadel 16, entweder zwischen den Wandungen des Ausrichtdurchbruchs 19 aufgrund des dort durch die Verjüngung gebildeten Klemmspalts gehalten wird, sodass eine axiale Verschiebung der Kontaktnadel 16 erschwert wird und dadurch ein ungewolltes Herausrutschen der Kontaktnadel 16 aus dem Kontaktkopf 1 verhindert ist, oder es liegt keine Klemmung auf den Querschnittsumriss 29 vor, weil dieser sich radial verlagert hat und somit in einen Bereich des Querschnitts des asymmetrischen Ausrichtdurchbruchs 19 gelangt ist, wo eine freie axiale Verschieblichkeit besteht. Zusammenfassend ist also bei der Betrachtung des gesamten Kontaktkopfes 1 festzustellen, dass die Ausrichtdurchbrüche 19 jeweils eine Querschnittskontur 30 aufweisen, die in mindestens einer radialen Richtung 34 (Figur 5) einen Klemmrandkonturbereich 31 und die in mindestens einer anderen radialen Richtung 35 einen klemmfreien Randkonturbereich 32 für den dort liegenden Querschnittsumriss 29 der zugeordneten, zumindest einen Bogen 20 aufweisenden Kontaktnadel 16 besitzt.

Die Figur 5 verdeutlicht die vorstehenden Ausführungen. Auf der linken Seite ist eine Querschnittsansicht im Bereich des Ausrichtdurchbruchs 19 der Figur 3 und auf der rechten Seite der Figur 5 eine entsprechende Ansicht der Figur 4 gezeigt. In der Mitte der Figur 5 wird angedeutet, in welcher Richtung die Kontaktnadel 16 durchgebogen ist (Bogenrichtung B). Die Querschnittskontur 30 des Ausrichtdurchbruchs 19 kann - nach dem aus der Figur 5 hervorgehenden Ausführungsbeispiel - etwa tropfenförmig gestaltet sein. Hierdurch ist die erwähnte Asymmetrie gegeben und auch eine Verjüngung 33 erzeugt. Es wird deutlich, dass der in diesem Ausführungsfalle kreisförmige Querschnittsumriss 29 der Kontaktnadel 16 in der radialen Richtung 34 in die Verjüngung 33 gelangt, dass also dort aufgrund der Verjüngung der Klemmrandkonturbereich 31 der Querschnittskontur 30 liegt. Die Folge ist ein axiales Festsetzen der Kontaktnadel 16 in dem Ausrichtdurchbruch 19. Die vorstehende Situation ergibt sich im nicht kontaktierten Zustand des Prüfkopfs 1 gemäß Figur 3. Wird nun der kontaktierte Zustand herbeigeführt, d.h., die Kontaktnadel 16 kontaktiert den Prüfkontakt 4 des Prüflings 2, so verstärkt sich die Durchbiegung der Kontaktnadel 16, d.h., der Bogen 20 vergrößert sich in Bogenrichtung 20 mit der Folge, dass die Situation gemäß der rechten Seite der Figur 5 und der Figur 4 herbeigeführt wird. Der Querschnittsumriss 29 der Kontaktnadel 16 verlässt den Klemmrandkonturbereich 31 und bewegt sich in den klemmfreien Randkonturbereich 32 der Querschnittskontur 30 des Ausrichtdurchbruchs 19. Die Querschnittskontur 30 des Ausrichtdurchbruchs 19 weist den klemmfreien Randkonturbereich 32 in der radialen Richtung 35 auf, die gegenüber der vorstehend bereits erwähnten radialen Richtung 34 in eine andere Richtung weist. Im dargestellten Ausführungsbeispiel weisen die beiden radialen Richtungen 34 und 35 in um 180° entgegengesetzte Richtungen. Im klemmfreien Randkonturbereich 32 kann sich die Kontaktnadel 16 frei axial bewegen.

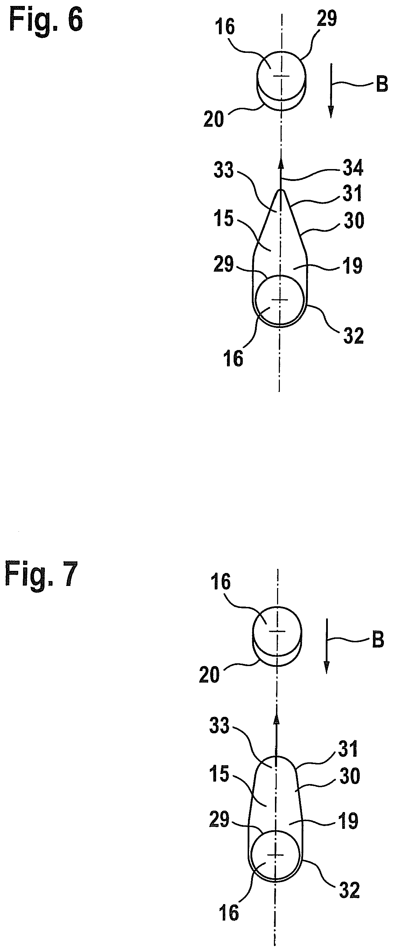

Die Figuren 6 bis 8 zeigen Querschnittsansichten von Ausrichtdurchbrüchen 19 verschiedener Ausführungsbeispiele der Erfindung. Die Figur 6 zeigt eine etwa tropfenförmige Querschnittskontur 30 des Ausrichtdurchbruchs 19. Der oberhalb des Ausrichtdurchbruchs 19 dargestellte Querschnittsumriss 29 der Kontaktnadel 16 verdeutlicht lediglich in Bezug auf die darunter liegende Querschnittskontur 30 des Ausrichtdurchbruchs 19 die Ausrichtung der Kontaktnadel 16 in Bezug auf ihren mindestens einen Bogen 20. Die Anordnung ist derart getroffen, dass die Bogenrichtung B in der Figur 6 um 180° entgegengesetzt zur radialen Richtung 34 liegt, die dem Klemmrandkonturbereich 31 zugeordnet ist.

In Figur 7 liegen entsprechende Verhältnisse vor, so wie sie bei der Figur 6 dargestellt wurden. Es wird insofern Bezug auf die Figur 6 genommen. Unterschiedlich ist lediglich, dass bei diesem Ausführungsbeispiel die Querschnittskontur 30 des Ausrichtdurchbruchs 19 in Bezug auf die Verjüngung 33 weniger spitz ausläuft, sondern eher abgerundet ausgebildet ist. Selbstverständlich sind noch viele andere Querschnittskonturen 30 denkbar, die in einer radialen Richtung 34 einen Klemmrandkonturbereich 31 und in einer anderen radialen Richtung 35 einen klemmfreien Randkonturbereich 32 aufweisen.

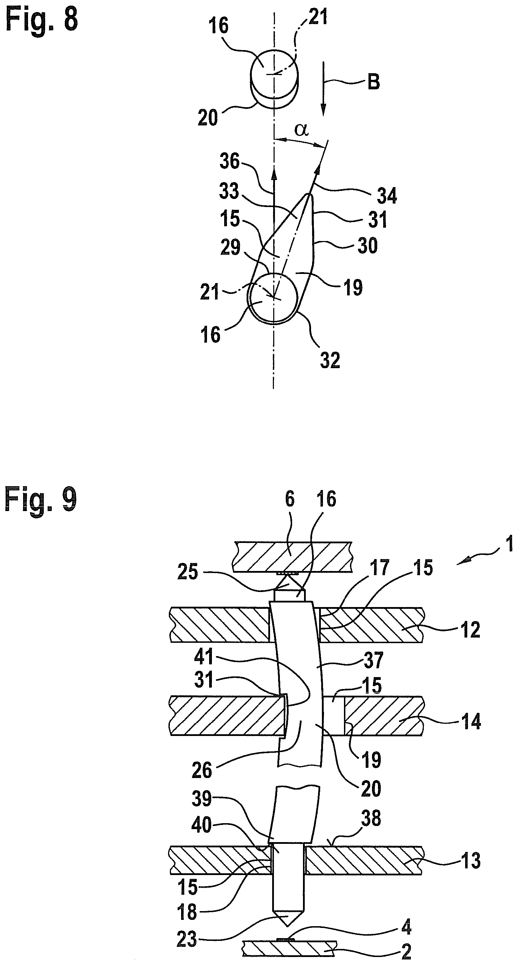

Das Ausführungsbeispiel der Figur 8 entspricht dem Ausführungsbeispiel der Figur 6, sodass auf die Figur 6 Bezug genommen wird. Unterschiedlich ist lediglich, dass eine der Bogenrichtung B des Bogens 20 entgegengesetzte radiale Richtung 36 mit der radialen Richtung 34 des zugeordneten Klemmrandkonturbereichs 31 einen spitzen Winkel α einschließt. Die Folge ist, dass bei der Radialbewegung des Bereichs 26 der Kontaktnadel 16 ein Drehmoment entsteht, dass also die Kontaktnadel 16 um ihre Längsmittelachse 21 herum verdreht wird, wodurch die Berührungskontakteigenschaften zum Prüfkontakt 4 des Prüflings 2 und zur Kontaktfläche 24 verbessert werden.

Die Figur 9 zeigt ein Ausführungsbeispiel, dass den vorstehend erwähnten Ausführungsbeispielen entspricht und daher Bezug auf die vorstehenden Ausführungsbeispiele genommen wird. Unterschiedlich ist lediglich, dass die Kontaktnadel 16 mit einer Isolierung 37 versehen ist. Die Isolierung 37 erstreckt sich - ausgehend von dem der Kontaktabstandumsetzeinrichtung 5 naheliegenden Ende 25 durch den Führungsdurchbruch 17, durch den Ausrichtdurchbruch 19 bis zu der dem Prüfling 2 abgewandt liegenden Oberfläche 38 der prüflingsnahen Führungsplatte 13. Dabei ist die Anordnung derart getroffen, dass der mit Isolierung 37 versehene Querschnitt 39 der Kontaktnadel 16 größer ist, als der Querschnitt des Führungsdurchbruchs 18 der Führungsplatte 13. Die Folge ist, dass sich die Stirnseite 40 der Isolierung 37 an der Oberfläche 38 der Führungsplatte 13 abstützt. Hierdurch wird ein Herausziehschutz der Kontaktnadel 16 geschaffen. Hinzutritt der Herausziehschutz durch den Klemmrandkonturbereich 31. Zusätzlich kann vorgesehen sein, dass die Isolierung 37 aus einem Material, vorzugsweise aus Polyimid, besteht, das durch Klemmung im Klemmrandkonturbereich 31 des Ausrichtdurchbruchs 19 eine Einkerbung 41 beziehungsweise Stufe oder dergleichen erhält, mit der Folge, dass hierdurch ein weiterer Herausziehschutz für die Kontaktnadel 16 bewirkt ist, da die Einkerbung 41 /Stufe oder dergleichen sich am Klemmrandkonturbereich 31 axial abstützt. Diese Abstützung wird aufgehoben, sobald die Kontaktnadel 16 für den Kontaktierungsvorgang den Klemmrandkonturbereich 31 verlässt.

Die zumeist anhand nur einer Kontaktnadel 16 vorstehend beschriebenen Ausführungen gelten vorzugsweise für alle Kontaktnadeln 16 des Kontaktkopfs 1, zumindest jedoch für eine gewisse Anzahl von ihnen. Durch die Erfindung verbessert sich der Halt der Kontaktnadeln 16 im Kontaktkopf 1, sodass Probleme durch teilweise oder ganz herausgezogene Kontaktnadeln 16 der Vergangenheit angehören. Durch die Formgebung der Ausrichtdurchbrüche 19 lässt sich die Intensität der Klemmung beeinflussen. Ein Winkel zwischen der Bogenrichtung B der Kontaktnadel 16 und der Ausrichtung des durch die Verjüngung 33 gebildeten Klemmspalts des Ausrichtdurchbruchs 19 führt zu Drehbewegungen der Kontaktnadel 16, wodurch die Kontaktierung insbesondere zum Prüfling 2 verbessert wird. Zur Erzeugung der Einkerbung 41 beziehungsweise Stufe oder sogar einer Durchtrennung der Isolierung 37 der Kontaktnadel 16 ist anzumerken, dass sich dieser Rückhalt durch Benutzung selbst bildet, sodass also bei der Herstellung des Kontaktkopfes 1 hierzu keine Arbeiten erforderlich sind und insbesondere auch keine Toleranzen berücksichtigt werden müssen, die zu unterschiedlichen Lagen der Einkerbungen/Stufen/Durchtrennungen führen würden. Vielmehr werden die Individualitäten des Aufbaus des Kontaktkopfes 1 eigenständig beachtet. Die Erfindung erfordert gegenüber dem Stand der Technik nur sehr geringfügige Änderungen, denn es ist lediglich die Querschnittsgeometrie der Ausrichtdurchbrüche 19 zu verändern.

## Patentansprüche

1. Kontaktkopf (1) zur Berührungskontaktierung eines elektrischen Prüflings (2), insbesondere Wafers, mit in Aufnahmedurchbrüchen gelagerten Kontaktnadeln (16) und mit mindestens zwei beabstandet zueinander angeordneten Führungsplatten (12, 13) sowie mit mindestens einer mit Abstand zu den Führungsplatten (12, 13) liegenden Offsetplatte (14), wobei die Führungsplatten (12, 13) Führungsdurchbrüche (17, 18) und die Offsetplatte (14) Ausrichtdurchbrüche (19) aufweisen, die Führungsdurchbrüche (17, 18) und die Ausrichtdurchbrüche (19) die Aufnahmedurchbrüche bilden, und die Kontaktnadeln (16) jeweils einen der Führungsdurchbrüche (17) der einen Führungsplatte (12), einen der Führungsdurchbrüche (18) der anderen Führungsplatte (13) sowie einen der Ausrichtdurchbrüche (19) der Offsetplatte (14) durchsetzen, **dadurch gekennzeichnet, dass** die Ausrichtdurchbrüche (19) jeweils eine asymmetrische Querschnittskontur (30) aufweisen, die in mindestens einer radialen Richtung (34) einen Klemmrandkonturbereich (31) und die in mindestens einer anderen radialen Richtung (35) einen klemmfreien Randkonturbereich (32) für den dort liegenden Querschnittsumriss (29) der zugeordneten, zumindest einen Bogen (20) aufweisenden Kontaktnadel (16) besitzt, wobei der Klemmrandkonturbereich (31) einen sich in radialer Richtung (34) verengenden Klemmspalt für die zugeordnete Kontaktnadel (16) bildet, der dazu eingerichtet ist, auf die Kontaktnadel (16) eine Klemmung auszuüben, wenn sie im sich verengenden Klemmspalt (33) einliegt.

2. Kontaktkopf nach Anspruch 1, **dadurch gekennzeichnet, dass** die Kontaktnadeln (16) im nichtmontierten Zustand einen geradlinigen Verlauf aufweisen.

3. Kontaktkopf nach einem der vorhergehenden Ansprüche, **dadurch gekennzeichnet, dass** die Kontaktnadeln (16) Knicknadeln sind.

4. Kontaktkopf nach einem der vorhergehenden Ansprüche, **dadurch gekennzeichnet, dass** die der jeweiligen Kontaktnadel (16) zugeordneten Aufnahmedurchbrüche (15) fluchtend und/oder versetzt zueinander angeordnet sind.

5. Kontaktkopf nach einem der vorhergehenden Ansprüche, **dadurch gekennzeichnet, dass** die Führungsplatten (12,13) und die Offsetplatte (14) jeweils eben ausgebildet sind.

6. Kontaktkopf nach einem der vorhergehenden Ansprüche, **dadurch gekennzeichnet, dass** die Führungsplatten (12,13) und die Offsetplatte (14) parallel zueinander verlaufen.

7. Kontaktkopf nach einem der vorhergehenden Ansprüche, **dadurch gekennzeichnet, dass** die Offsetplatte (14) zwischen den Führungsplatten (12,13) angeordnet ist.

8. Kontaktkopf nach einem der vorhergehenden Ansprüche, **dadurch gekennzeichnet, dass** die Ausrichtdurchbrüche (19) jeweils nur einen einzigen Klemmrandkonturbereich (31) aufweisen.

9. Kontaktkopf nach einem der vorhergehenden Ansprüche, **dadurch gekennzeichnet, dass** die Querschnittskonturen (30) der Ausrichtdurchbrüche (19) als tropfenförmige Konturen oder ähnlich tropfenförmiger Konturen ausgebildet sind.

10. Kontaktkopf nach einem der vorhergehenden Ansprüche, **dadurch gekennzeichnet, dass** die Bogenrichtung (B) des Bogens (20) der jeweiligen Kontaktnadel (16) entgegengesetzt zur radialen Richtung (34) des zugeordneten Klemmrandkonturbereichs (31) verläuft.

11. Kontaktkopf nach einem der vorhergehenden Ansprüche, **dadurch gekennzeichnet, dass** - insbesondere im kontaktierten Zustand des Prüfkopfs (1) - eine der Bogenrichtung (B) des Bogens (20) entgegengesetzte radiale Richtung (36) mit der radialen Richtung (34) des zugeordneten Klemmrandkonturbereichs (31) einen spitzen Winkel (a) einschließt.

12. Kontaktkopf nach einem der vorhergehenden Ansprüche, **dadurch gekennzeichnet, dass** die Kontaktnadeln (16) jeweils zumindest in ihrem den Ausrichtdurchbruch (19) durchsetzenden Bereich (26) eine Isolierung (37) aufweisen.

13. Kontaktkopf nach einem der vorhergehenden Ansprüche, **dadurch gekennzeichnet, dass** die Führungsdurchbrüche (18) der dem Prüfling (2) zugewandt liegenden Führungsplatte (13) jeweils einen Querschnitt aufweisen, der kleiner ist als der mit Isolierung (37) versehene Querschnitt der zugeordneten Kontaktnadel (16), wobei die Isolierung (37) an der dem Prüfling (2) abgewandt liegenden Oberfläche (38) dieser Führungsplatte (13) endet.

14. Kontaktkopf nach einem der vorhergehenden Ansprüche, **dadurch gekennzeichnet, dass** die Isolierungen (37) der Kontaktnadeln (16) durch die Klemmwirkungen der Klemmrandkonturbereiche (31) bewirkte Einkerbungen (41) /Stufen oder Durchtrennungen aufweisen.

15. Kontaktkopf nach einem der vorhergehenden Ansprüche, **dadurch gekennzeichnet, dass** die Isolierung (37) aus Polyimid besteht.

## Claims

1. Contact head (1) for touch contacting an electric test object (2), in particular a wafer, comprising contact needles (16) mounted in receiving openings and comprising at least two mutually spaced apart guide plates (12, 13) as well as at least one offset plate (14) which lies at a distance from the guide plates (12, 13), wherein the guide plates (12, 13) have guide openings (17, 18) and the offset plate (14) has alignment openings (19), wherein the guide openings (17, 18) and the alignment openings (19) form the receiving openings, and wherein each of the contact needles (16) passes through one of the guide openings (17) of one guide plate (12), one of the guide openings (18) of the other guide plate (13) and one of the alignment openings (19) of the offset plate (14), **characterised in that** each of the alignment openings (19) has an asymmetrical cross-sectional contour (30) which has a clamping edge contour region (31) in at least one radial direction (34) and a non-clamping edge contour region (32) in at least one other radial direction (35) for the cross-sectional outline (29) positioned therein of the associated contact needle (16) which has at least one arc (20), the clamping edge contour region (31) forming a clamping gap tapering in the radial direction (34) for the associated contact needle (16), the clamping gap being constructed to exert a clamping action on the contact needle (16) when it is positioned in the tapering clamping gap (33).

2. Contact head according to claim 1, **characterised in that** the contact needles (16) have a straight extension in the unmounted state.

3. Contact head according to any one of the preceding claims, **characterised in that** the contact needles (16) are buckling beams.

4. Contact head according to any one of the preceding claims, **characterised in that** the receiving openings (15) assigned to the respective contact needle (16) are in alignment with and/or offset from one another.

5. Contact head according to any one of the preceding claims, **characterised in that** the guide plates (12,13) and the offset plate (14) are each flat.

6. Contact head according to any one of the preceding claims, **characterised in that** the guide plates (12,13) and the offset plate (14) extend parallel to one another.

7. Contact head according to any one of the preceding claims, **characterised in that** the offset plate (14) is arranged between the guide plates (12,13).

8. Contact head according to any one of the preceding claims, **characterised in that** the alignment openings (19) each have only a single clamping edge contour region (31).

9. Contact head according to any one of the preceding claims, **characterised in that** the cross-sectional contours (30) of the alignment openings (19) are configured as drop-shaped contours or similar to drop-shaped contours.

10. Contact head according to any one of the preceding claims, **characterised in that** the direction of curvature (B) of the arc (20) of each contact needle (16) extends opposed to the radial direction (34) of the associated clamping edge contour region (31).

11. Contact head according to any one of the preceding claims, **characterised in that** - in particular in the contacted state of the contact head (1) - a radial direction (36) opposing the direction of curvature (B) of the arc (20) encloses an acute angle (α) with the radial direction (34) of the associated clamping edge contour region (31).

12. Contact head according to any one of the preceding claims, **characterised in that** the contact needles (16) each have an insulation (37) at least in the region (26) thereof which passes through the alignment opening (19).

13. Contact head according to any one of the preceding claims, **characterised in that** the guide openings (18) of the guide plate (13) facing the test object (2) each have a cross-section which is smaller than the cross-section of the associated contact needle (16) provided with the insulation (37), with the insulation (37) ending on the surface (38) of this guide plate (13) facing away from the test object (2).

14. Contact head according to any one of the preceding claims, **characterised in that** the insulation (37) of the contact needles (16) has notches (41)/steps or divisions effected by means of the clamping actions of the clamping edge contour regions (31).

15. Contact head according to any one of the preceding claims, **characterised in that** the insulation (37) consists of polyimide.

## Revendications

1. Tête de contact (1) pour contact tactile d'un objet de test (2) électrique, en particulier de tranche, avec des aiguilles de contact (16) supportées dans des passages de réception et avec au moins deux plaques de guidage (12, 13) disposées à distance l'une de l'autre, ainsi qu'avec au moins une plaque de décalage (14) située à distance des plaques de guidage (12, 13), les plaques de guidage (12, 13) comportant des passages de guidage (17, 18), et la plaque de décalage (14) comportant des passages d'alignement (19), les passages de guidage (17, 18) et les passages d'alignement (19) formant les passages de réception, et les aiguilles de contact (16) pénétrant respectivement dans l'un des passages de guidage (17) d'une plaque de guidage (12), dans l'un des passages de guidage (18) de l'autre plaque de guidage (13) ainsi que dans l'un des passages d'alignement (19) de la plaque de décalage (14), **caractérisée en ce que** les passages d'alignement (19) comportent respectivement un contour de section transversale (30) asymétrique qui, dans au moins une direction radiale (34), possède une zone de contour de bord de serrage (31) et qui, dans au moins une autre direction radiale (35), possède une zone de contour de bord (32) sans serrage pour le périmètre de section transversale (29), situé à cet endroit, de l'aiguille de contact (16) affectée présentant au moins un arc (20), la zone de contour de bord de serrage (31) formant un interstice de serrage, se rétrécissant dans la direction radiale (34), pour l'aiguille de contact (16) affectée, qui est agencé pour exercer un serrage sur l'aiguille de contact (16) si elle est située dans l'interstice de serrage (33) qui se rétrécit.

2. Tête de contact selon la revendication 1, **caractérisée en ce que**, dans l'état non monté, les aiguilles de contact (16) présentent un tracé rectiligne.

3. Tête de contact selon l'une des revendications précédentes, **caractérisée en ce que** les aiguilles de contact (16) sont des aiguilles coudées.

4. Tête de contact selon l'une des revendications précédentes, **caractérisée en ce que** les passages de réception (15) affectés à l'aiguille de contact (16) respective sont disposés en affleurement et/ou de façon décalée les uns par rapport aux autres.

5. Tête de contact selon l'une des revendications précédentes, **caractérisée en ce que** les plaques de guidage (12, 13) et la plaque de décalage (14) sont respectivement constituées de façon plane.

6. Tête de contact selon l'une des revendications précédentes, **caractérisée en ce que** les plaques de guidage (12, 13) et la plaque de décalage (14) sont parallèles entre elles.

7. Tête de contact selon l'une des revendications précédentes, **caractérisée en ce que** la plaque de décalage (14) est disposée entre les plaques de guidage (12, 13).

8. Tête de contact selon l'une des revendications précédentes, **caractérisée en ce que** les passages d'alignement (19) ne comportent respectivement qu'une seule zone de contour de bord de serrage (31).

9. Tête de contact selon l'une des revendications précédentes, **caractérisée en ce que** les contours de section transversale (30) des passages d'alignement (19) sont réalisés en tant que contours en forme de goutte ou en tant que contours de forme semblable à une goutte.

10. Tête de contact selon l'une des revendications précédentes, **caractérisée en ce que** la direction d'arc (B) de l'arc (20) de l'aiguille de contact (16) respective est opposée à la direction radiale (34) de la zone de contour de bord de serrage (31) affectée.

11. Tête de contact selon l'une des revendications précédentes, **caractérisée en ce que** - en particulier dans l'état mis en contact de la tête de contact (1) - une direction radiale (36) opposée à la direction d'arc (B) de l'arc (20) forme un angle aigu (α) avec la direction radiale (34) de la zone de contour de bord de serrage (31) affectée.

12. Tête de contact selon l'une des revendications précédentes, **caractérisée en ce que** les aiguilles de contact (16) comportent respectivement une isolation (37) au moins dans leur zone (26) pénétrant dans le passage d'alignement (19).

13. Tête de contact selon l'une des revendications précédentes, **caractérisée en ce que** les passages de guidage (18) de la plaque de guidage (13) tournée vers le objet de test (2) comportent respectivement une section transversale qui est plus petite que la section transversale de l'aiguille de contact (16) qui est affectée et qui est munie de l'isolation (37), l'isolation (37) se terminant sur la surface (38) de cette plaque de guidage (13) qui est éloignée du objet de test (2).

14. Tête de contact selon l'une des revendications précédentes, **caractérisée en ce que** les isolations (37) des aiguilles de contact (16) comportent des encoches (41) / gradins ou découpes provoqué(e)s par les actions de serrage des zones de contour de bord de serrage (31).

15. Tête de contact selon l'une des revendications précédentes, **caractérisée en ce que** l'isolation (37) se compose de polyimide.
